Europäisches Patentamt

European Patent Office

Office européen des brevets

(11) Publication number: **0 218 084 B1**

# EUROPEAN PATENT SPECIFICATION

(45) Date of publication of patent specification: **06.05.92**  (51) Int. Cl.5: **H01L 27/06**, H01L 21/82

(21) Application number: **86111964.2**

(22) Date of filing: **29.08.86**

(54) Semiconductor device having a MOS transistor and method of manufacturing the same.

(30) Priority: **30.08.85 JP 191568/85**

(43) Date of publication of application:
**15.04.87 Bulletin 87/16**

(45) Publication of the grant of the patent:
**06.05.92 Bulletin 92/19**

(84) Designated Contracting States:
**DE FR GB**

(56) References cited:
**GB-A- 1 153 462
GB-A- 2 060 252
US-A- 4 138 782**

**PROCEEDINGS OF THE S.I.D. vol. 23, no. 3,
1982, pages 187-195; B. CHOY et al.: "A high-
voltage IC chip set for use as EL panel
drivers"**

**IEEE TRANSACTIONS ON ELECTRON DE-
VICES vol. ED-31, no.1, January 1984, pages
89-95; S.KRISHNA et al.: "An analog technol-
ogy integrates bipolar, CMOS, and high-
voltage DMOS transistors"**

(73) Proprietor: **KABUSHIKI KAISHA TOSHIBA
72, Horikawa-cho Saiwai-ku
Kawasaki-shi Kanagawa-ken 210(JP)**

(72) Inventor: **Shirai, Koji Patent Division
K.K. Toshiba 1-1, Shibaura 1-chome
Minato-ku Tokyo 105(JP)**
Inventor: **Kawamura, Ken Patent Division
K.K. Toshiba 1-1, Shibaura 1-chome
Minato-ku Tokyo 105(JP)**

(74) Representative: **Eitle, Werner, Dipl.-Ing. et al
Hoffmann, Eitle & Partner Patentanwälte Ar-
abellastrasse 4
W-8000 München 81(DE)**

EP 0 218 084 B1

Rank Xerox (UK) Business Services
(3.08/2.18/2.0)

## Description

The present invention relates to a semiconductor device having a MOS transistor and a method of manufacturing the same.

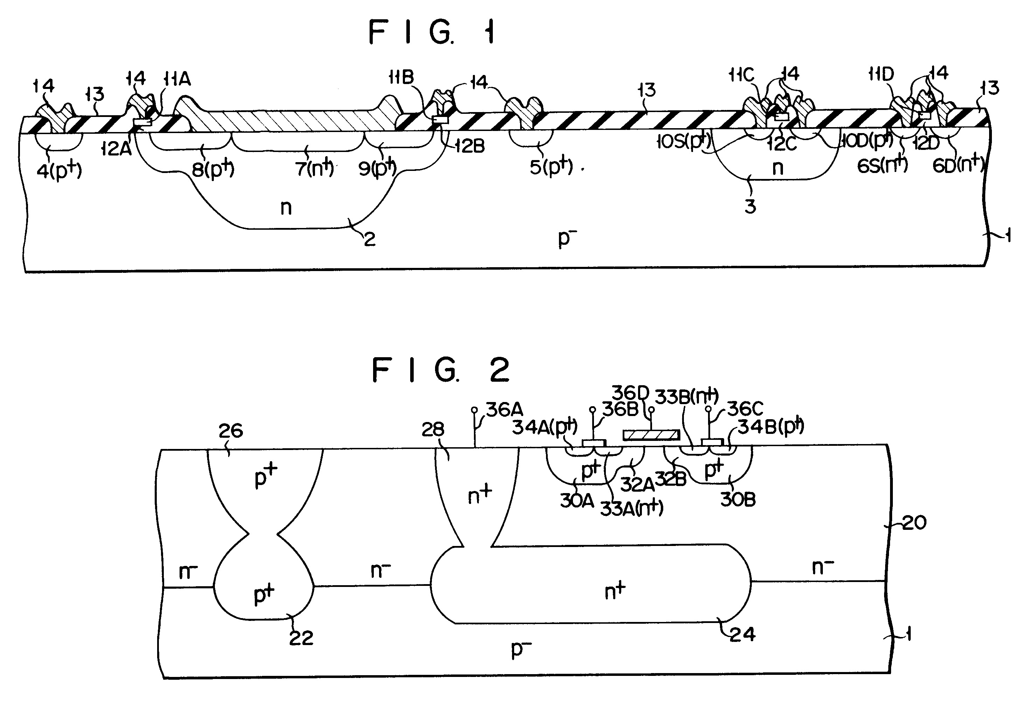

A semiconductor device having double diffusion MOS and CMOS transistors available from Supertex Inc. (see e.g. B. Choy et al., Proc. of the S.I.D. vol. 23, no. 3, p. 187-195, 1982), a Bi-DFET available from Texas Instruments, Inc., and the like are known as conventional high- voltage LSI devices. A typical semiconductor device of this type is shown in Fig. 1.

The semiconductor device in Fig. 1 comprises $p^-$-type semiconductor substrate 1, n-wells 2 and 3, $p^+$-type regions 4 and 5, and $n^+$-type regions 6S and 6D which are formed in the surface area of substrate 1. Regions 4 and 5 constitute drains of p-channel type lateral DMOS transistors. Regions 6S and 6D constitute the source and drain of the n-channel MOS transistor in the CMOS transistor device. $N^+$-type region 7 and $p^+$-type regions 8 and 9 constituting the sources of the DMOS transistors are formed in the surface area of n-well 2. $p^+$-type regions 10S and 10D constituting the source and drain of the p-channel MOS transistor in the CMOS transistor device are formed in the surface area in n-well 3.

Gate electrodes 11A to 11D are formed on substrate 1 through gate oxide films 12A to 12D. Electrodes 11A and 11B constitute the gates of the DMOS transistors. Electrodes 11C and 11D constitute the gates of p- and n-channel MOS transistors of the CMOS transistor device. Insulating layer 13 is formed on substrate 1 and electrodes 11A to 11D. Contact holes are formed in those portions of insulating layer 13 which lie on $p^+$-type regions 4, 5, 8, 9, 10D and 10S, $n^+$-type regions 6D, 6S, and 7, and gate electrodes 11A to 11D. For example, Al metal electrodes 14 are formed in these contact holes.

In the semiconductor device having the above structure, since drain regions 4 and 5 of the lateral DMOS transistors are directly connected to substrate 1, it is impossible to alter the circuit design in a variety of applications. In other words, it is impossible to achieve multifunction which is regarded as the most important factor in IC and LSI circuits. In a conventional semiconductor device of this type, the use of lateral DMOS transistors requires a large element area to attain drive operation with a large current.

Fig. 2 shows another conventional DMOS transistor device having a vertical isolation layer (see e.g. S.Krishna et al., IEEE Transactions on Electron Devices vol. ED-31, no. 1, p. 89-95, 1984). This transistor device includes $n^-$-type epitaxial layer 20 formed on $p^-$-type substrate 1, $p^+$-type and $n^+$-type buried layers 22 and 24 formed in the boundary region between substrate 1 and epitaxial layer 20, and $p^+$-type isolation layer 26 and deep $n^+$-type layer 28 both of which are obtained by diffusing the corresponding impurities from the surface of epitaxial layer 20 and reaching buried layers 22 and 24. $P^+$-type body regions 30A and 30B are formed in the surface area of epitaxial layer 20. $P^+$-type base regions 32A and 32B are formed in the surface area of layer 20 and respectively are in contact with regions 30A and 30B. $N^+$-type source regions 33A and 33B and $P^{++}$-type contact regions 34A and 34B are respectively formed in body regions 30A and 30B. Drain electrode 36A is formed to be electrically connected with $n^+$-type layer 28, and source electrodes 36B and 36C are respectively formed to be electrically connected with regions 33A and 33B. Gate electrode 36D is formed on a region between source regions 33A and 33B through an insulation layer (not shown).

In the DMOS transistor device described above, bidirectional isolation is utilized for element isolation so that the thickness of epitaxial layer 20 is preferably minimized. Formation of a vertical DMOS transistor requires formation of $n^+$-type layer 28 to be connected to the metal drain electrode. If the thickness of epitaxial layer 20 is increased to obtain a higher dielectric withstand voltage, it is difficult to form layer 28. In addition, the resistance of layer 28 as a function of a current flowing therethrough is increased. A lateral DMOS transistor may be formed in place of the vertical DMOS transistor. However, in order to flow a large current, a large element area is required.

In order to form a DMOS transistor or a bipolar transistor together with a CMOS transistor on one chip, impurity regions of a high concentration such as isolation layer 26 and deep $n^+$-type layer 28 must be deeply formed prior to formation of elements. Layers 26 and 28 are kept exposed even at the time of formation of a MOS transistor or the like. For example, impurity ions are scattered from layers 26 and 28 upon formation of, for example, a gate oxide film and are diffused into the channel region of the MOS transistor, thus influencing a threshold voltage of the MOS transistor. Therefore, micropatterning of the CMOS transistor has limitations according to conventional patterning techniques.

It is an object of the present invention to provide a compact semiconductor device having a DMOS transistor and capable of being driven with a large current and a method of manufacturing the same.

According to an aspect of the present invention, there is provided a semiconductor device including a semiconductor body of one conductivity type having at least first and second recesses, first and second semiconductor regions of an opposite conductivity type formed in a surface area of the first and second recesses in the semiconductor body, first and second epitaxial layers of the opposite conductivity type respectively formed in the first and second recesses in the semiconductor body and having an impurity concentration lower than that of the first and second semiconductor regions, a MOS transistor structure formed in the first epitaxial layer, and a double diffusion MOS transistor formed in the second epitaxial layer, whose drain includes the second semiconductor region and the second epitaxial layer.

According to another aspect of the present invention, there is provided a method of manufacturing a semiconductor device, comprising the steps of forming at least first and second recesses in one major surface of a semiconductor body of one conductivity type, forming first and second semiconductor regions of an opposite conductivity type in a surface area of the first and second recesses in the semiconductor body, forming first and second epitaxial layers having an impurity concentration lower than that of the first and second semiconductor regions in the first and second recesses, forming a MOS transistor structure in the first epitaxial layer, and forming a double diffusion MOS transistor in the second epitaxial layer.

According to the present invention, since the second semiconductor region serving as a drain is formed in substantially the entire surface area of the second recess, the semiconductor device can have a large operating current without increasing the element area.

This invention can be more fully understood from the following detailed description when taken in conjunction with the accompanying drawings, in which:

Fig. 1 is a sectional view showing a conventional semiconductor device having a lateral DMOS transistor;

Fig. 2 is a sectional view showing another conventional semiconductor device having a vertical DMOS transistor;

Figs. 3A to 3H are sectional views for explaining steps in manufacturing a semiconductor device according to an embodiment of the present invention;

Figs. 4 to 6 are enlarged sectional views of block areas A to C of the semiconductor device in Fig. 3E;

Fig 7 is an enlarged sectional view of block area D of the semiconductor device in Fig. 3F;

Figs. 8 to 10 are enlarged sectional views of block areas E to G of the semiconductor device in Fig. 3G; and

Figs. 11 and 12 are enlarged sectional views of a DMOS transistor and a CMOS transistor structure in Fig. 3H.

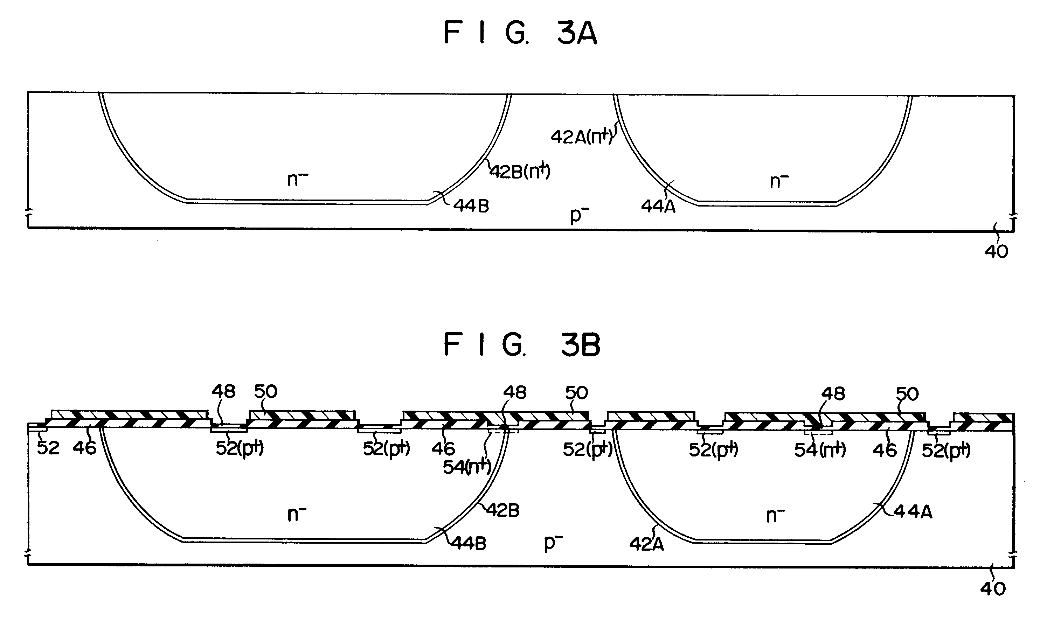

A process for manufacturing a semiconductor device according to an embodiment of the present invention will be described with reference to Figs. 3A to 3H. Recesses are formed in predetermined locations of $p^-$-type silicon substrate 40. First and second $n^+$-type layers 42A and 42B each having a thickness of 4 $\mu$m, for example, are formed on the surface portions in the recesses of substrate 40. An $n^-$-type epitaxial layer is formed on substrate 40 and layers 42A and 42B and is lapped to form epitaxial layers 44A and 44B on layers 42A and 42B so that layers 44A and 44B have substantially the same surface level as that of substrate 40, as shown in Fig. 3A.

Oxide film 46 is then formed on substrate 40 and epitaxial layers 44A and 44B and is patterned by a photoetching process (PEP) to form contact holes corresponding to regions subjected to impurity diffusion in the subsequent processes. Thin buffer oxide films 48 are formed in the contact holes, as shown in Fig. 3B. Resist film 50 is formed on the entire surface except for those oxide films 48 which correspond to $p^+$-type regions to be formed in the subsequent process. A p-type impurity is ion-implanted in substrate 40 and epitaxial layers 44A and 44B through exposed buffer oxide films 48 by using resist film 50 as a mask, thereby forming $p^+$-type impurity regions 52. Region 52 in epitaxial layer 44B is a ring-like region. Then, after resist film 50 is removed, another resist film (not shown) is formed to cover the entire surface except for those oxide films 48 which correspond to $n^+$-type impurity regions to be formed in the next step. An n-type impurity is ion-implanted in substrate 40, and epitaxial layers 44A and 44B by using the resist film as a mask, thereby forming $n^+$-type regions 54 indicated by broken lines in Fig. 3B. Since $n^+$-type regions 54 are not formed before resist film 50 is removed, regions 54 are indicated by broken lines in Fig. 3B.

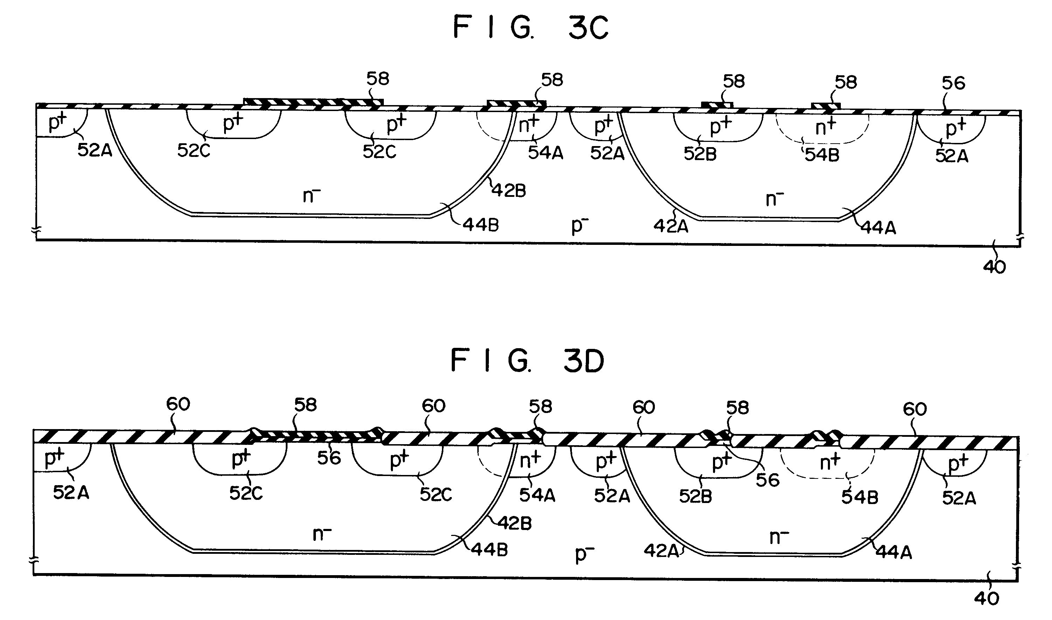

After the resist film used for forming regions 54 is removed, the entire structure is annealed to slump or thermally diffuse the impurity ions from impurity regions 52 and 54, thereby forming $p^+$- and $n^+$-type diffusion layers in substrate 40 and epitaxial layers 44A and 44B. As a result, as shown in Fig. 3C, $p^+$-type diffusion regions 52A and 52C are respectively formed in substrate 40 and epitaxial layer 44B. P-well 52B is formed in layer 44A. In addition, $n^+$-type diffusion region 54A is formed to surround that portion of layer 42B which lies near the surface of substrate 40. N-well 54B is formed in epitaxial layer 44A. $P^+$-type diffusion region 52A formed around $n^+$-type layer 42A is used as a channel stopper.

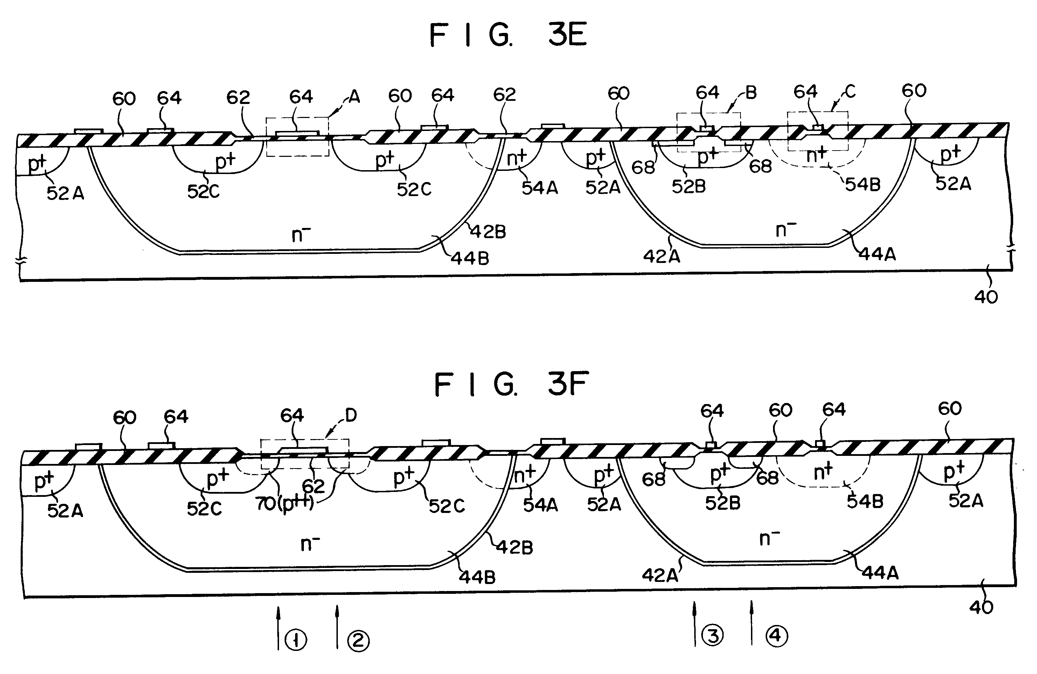

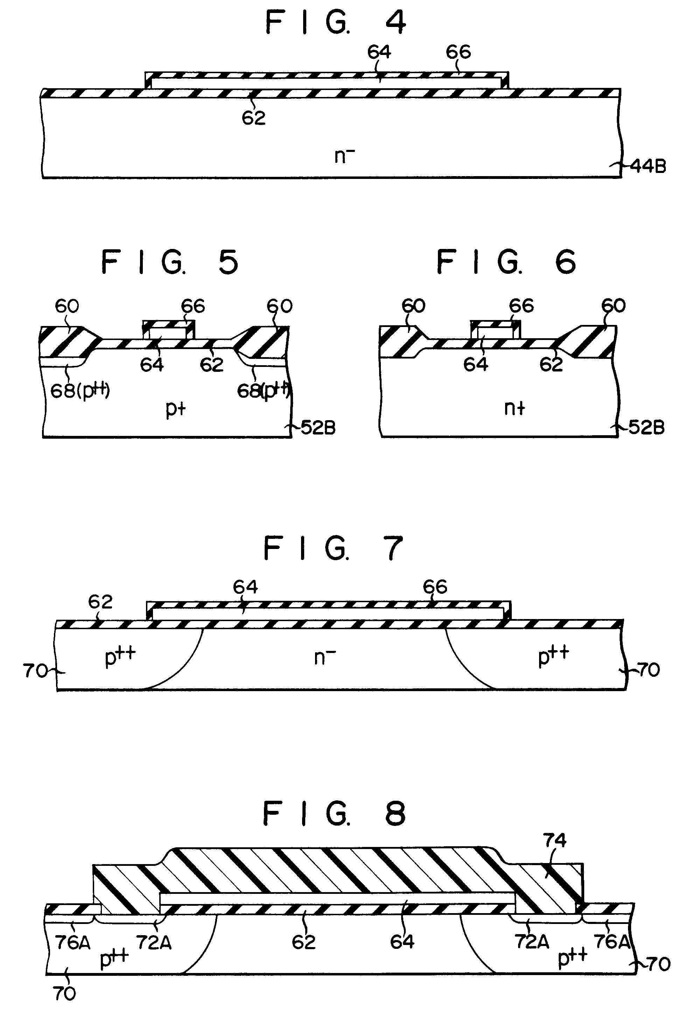

After oxide films 46 and 48 are removed, thin oxide film 56 is formed on substrate 40 and epitaxial layers 44A and 44B. $Si_3N_4$ film 58 is formed on films 56 to determine the position of the field oxide films to be formed. Oxide film 56 is selectively etched using film 58 as a mask, and the resultant pattern is selectively oxidized to form thick field oxide film 60, as shown in Fig. 3D. Thereafter, films 58 and 56 are removed, and gate oxide films 62 are formed in place of the removed films. At this stage, channel implantation is performed to control a threshold voltage of each MOS transistor. A polysilicon layer is formed on oxide films 60 and 62 selectively etched out by the PEP to form polysilicon layers 64. Layers 64 are slightly oxidized to form oxide films on the surfaces of polysilicon layers 64. For example, as shown in Fig. 4 showing a portion indicated by dotted block A in Fig. 3E, oxide film 66 is formed on the surface region of each layer 64. Figs. 5 and 6 are respectively enlarged views of dotted blocks B and C in fig. 3E. Polysilicon layers 64 serve as gate electrodes in blocks A, B, and C and as a wiring layer on field oxide film 60. A p-type channel stopper region 68 having an impurity concentration higher than p-well 52B is formed by ion-implantation immediately under part of field oxide film 60 which lies near the gate electrode 64 in block B. Region 68 may be formed prior to formation of field oxide film 60.

A p-type impurity is ion-implanted in $p^+$-type diffusion region 52A and epitaxial layer 44B through gate oxide film 62 located near gate electrode 64 in block A. The implanted ions are thermally diffused to form a ring-shaped base region 70, as shown in Fig. 3F. Fig. 7 is an enlarged view of the dotted block D in Fig. 3F.

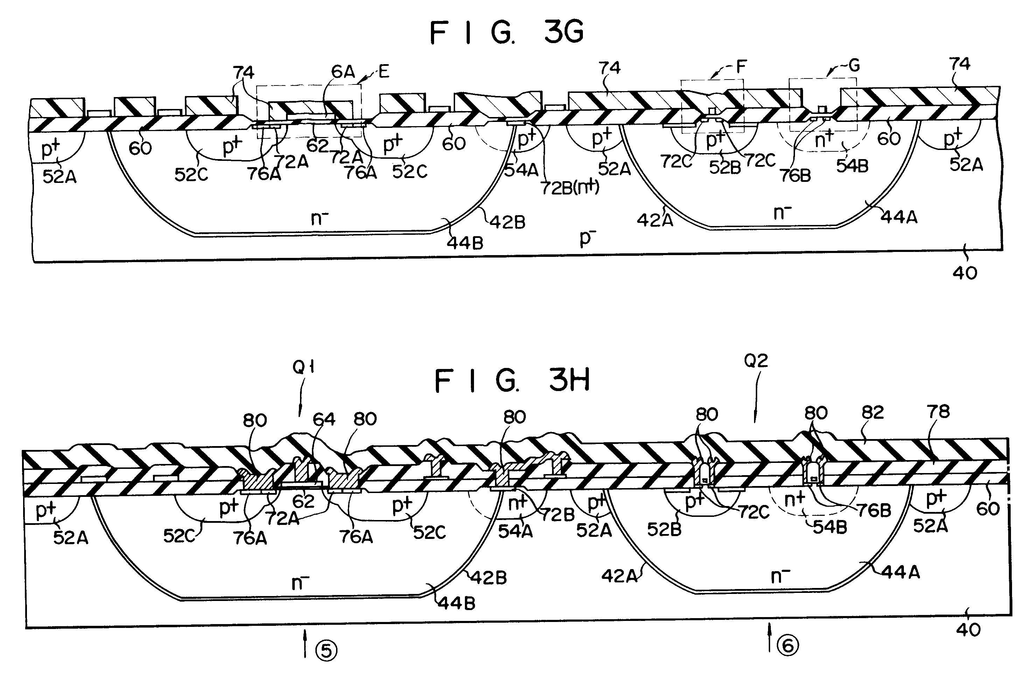

As shown in Fig. 3G, arsenic ions are implanted in the surface area of base region 70, diffusion region 54A and p-well 52B. Annealing is then performed to form $n^+$-type regions 72A in base region 70, $n^+$-type region 72B in diffusion region 54A, and $n^+$-type regions 72C serving as the source and drain in p-well region 52B. Region 72A serves as the source of the DMOS transistor, and region 72B serves as the drain contact region of the DMOS transistor. A resist film is formed and selectively etched away by the PEP to form resist mask 74. Boron ions are implanted in the surface area of diffusion region 52A and n-well 54B, and then annealing is performed to form $p^+$-type regions 76A within base region 70 so as to be in contact or contiguous with $n^+$-type region 72A, as shown in Fig. 3G. At the same time, $p^+$-type regions 76B serving as the source and drain of the p-channel MOS transistor are formed in n-well 54B. Figs. 8 to 10 are enlarged views of dotted blocks E, F and G in Fig. 3G. Region 76A serves as a back gate contact region of the DMOS transistor.

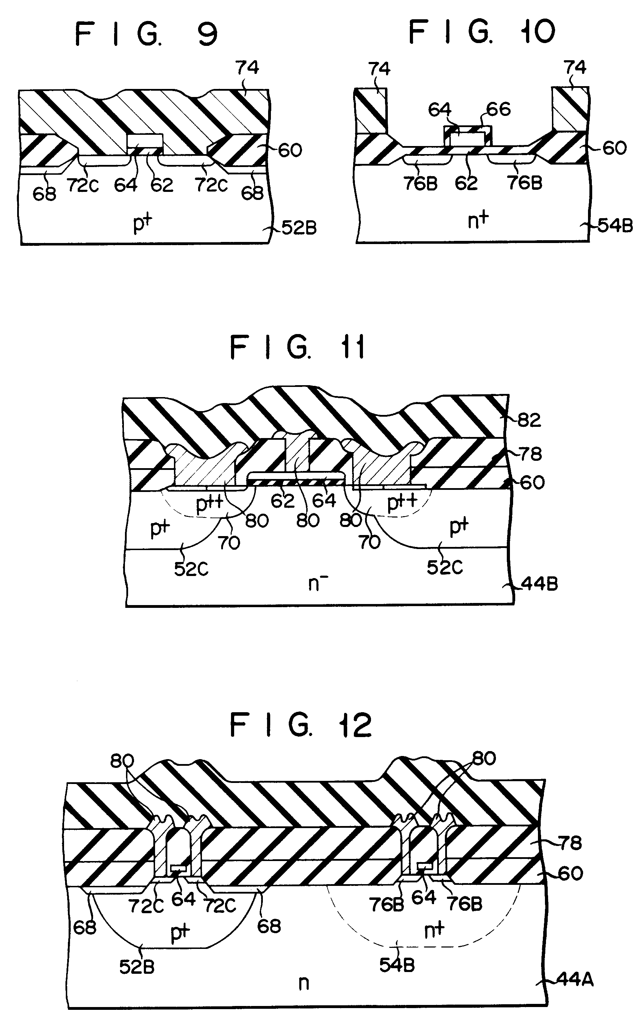

After resist mask 74 is removed, $CVD\text{-}SiO_2$ film 78 is formed on field oxide film 60. Films 78 and 56 are selectively etched away by the PEP to expose parts of $n^+$-type regions 72A, 72B and 72C, $p^+$-type regions 76A and 76B, and gate 64. Thereafter, as shown in Fig. 3H, aluminum is deposited on $SiO_2$ film 78 and the exposed regions and is patterned to form metal electrodes 80, as shown in Fig. 3H. Next, PSG film 82 is formed on film 78 and electrodes 80 to prepare a semiconductor device having DMOS transistor Q1 and CMOS transistor structure Q2. Figs. 11 and 12 are enlarged views of transistor Q1 and structure Q2 in Fig. 3H, respectively.

As described above, DMOS transistor Q1 and CMOS transistor structure Q2 are formed by many common fabrication steps. DMOS transistor Q1 can be formed by adding the step of forming $p^+$-type base region 70 to the fabrication steps of CMOS transistor structure Q2. Therefore, the semiconductor device in Fig. 3H can be manufactured on the mass production line substantially by using the conventional fabrication techniques with few modifications. Diffusion distance Xj in the diffusion region within the CMOS transistor structure is substantially equal to that of the conventional CMOS transistor. Therefore, the same design rule as in conventional design can be used in the present invention.

In the semiconductor device in Fig. 3H, epitaxial layers 44A and 44B are isolated from substrate 40 by $n^+$-type layers 42A and 42B. An isolation layer similar to isolation layer 26 occupying a large area as shown in Fig. 2, need not be formed. $N^+$-type layer 42B is formed to cover the entire bottom and side wall surfaces of epitaxial layer 44B, and drain contact region 72B is formed near the surface of substrate 40. Therefore, a large operating current can be obtained without increasing the size of the device. In addition, the thickness of epitaxial layers 44A and 44B can be easily controlled, and the bottoms thereof may be formed with proper curvature. As a result, the dielectric withstand voltages of DMOS transistor Q1 and CMOS transistor structure Q2 can be increased.

The present invention has been described with reference to the preferred embodiment but is not limited thereto. For example, n-well 54B is formed to constitute the n-channel MOS transistor of the CMOS transistor structure Q2 near the p-channel MOS transistor. However, n-well 54B may be omitted. In this case, an n-channel MOS transistor may be formed in epitaxial layer 44A. In the above embodiment, $n^+$-type region 54A is formed in order to reduce the radius of curvature of the p-n junction near drain contact region 72B of DMOS transistor Q1 so that the electric field can be prevented from being concentrated near this region, thereby increasing a dielectric withstand voltage between substrate 40 and the drain region constituted by regions 42B, 44B and 54A of DMOS transistor Q1. However, if the thickness of epitaxial layer 44B is sufficiently large, and the resultant dielectric withstand voltage is sufficiently high, $n^+$-type region 54A may be omitted. In addition, $p^+$-type diffusion region 52A is deeper than base region 70 to increase the dielectric withstand voltage between base and drain regions 70 and 44B. However, region 52A may be omitted as needed.

$P^+$-type regions 52 in epitaxial layer 44B and $p^+$-type region 52 in epitaxial layer 44A are simultaneously formed. However, region 52 in layer 44B may be formed to have an impurity concentration different from that of region 52 in layer 44A.

## Claims

1. A semiconductor device comprising:

a semiconductor body (40) of one conductivity type having at least first and second recesses;

first and second semiconductor regions (42A and 42B) of an opposite conductivity type formed in the surface areas of said first and second recesses in said semiconductor body (40);

first and second epitaxial layers (44A and 44B) of the opposite conductivity type respectively formed in said first and second recesses in said semiconductor body (40) and having an impurity concentration lower than that of said first and second semiconductor regions (42A and 42B);

a MOS transistor structure (Q2) formed in said first epitaxial layer (44B); and

a double diffusion MOS transistor (Q1) formed in said second epitaxial layer (44B), whose drain includes said second semiconductor region (42B) and said second epitaxial layer (44B).

2. A device according to claim 1, characterized in that said MOS transistor structure comprises a CMOS transistor structure including p- and n-channel MOS transistors.

3. A device according to claim 2, characterized in that said CMOS transistor structure includes p- and n-wells (52B and 54B) formed in the surface area of said first epitaxial layer (44A), and said p- and n-channel MOS transistors are respectively formed in said p- and n-wells (52B and 54B).

4. A device according to claim 1, 2, or 3, characterized by further comprising an impurity region (54A) of the opposite conductivity type formed to cover a portion of said second semiconductor region (42B) near the surface of said semiconductor body (40).

5. A device according to any one of claims 1 to 4, characterized in that junction surfaces between said semiconductor body (40) and said first and second semiconductor regions (42A and 42B) are arcuated.

6. A device according to any one of claims 1 to 5, characterized by further comprising at least one channel stopper of said one conductivity type having an impurity concentration higher than said semiconductor body (40) and formed in contact with said first semiconductor region (42A) in the surface area of said semiconductor body (40).

7. A method of manufacturing a semiconductor device, comprising the steps of: forming a least first and second recesses in one major surface of a semiconductor body (40) of one conductivity type; forming first and second semiconductor regions (42A and 42B) of an opposite conductivity type in the surface areas of said first and second recesses in said semiconductor body (40); forming first and second epitaxial layers (44A and 44B) having an impurity concentration lower than that of said first and second semiconductor regions (42A and 42B) in said first and second recesses; forming a MOS transistor structure (Q2) in said first epitaxial layer (44A); and forming a double diffusion MOS transistor (Q1) in said second epitaxial layer (44B).

## Revendications

1. Dispositif à semiconducteur comprenant :

un corps semiconducteur (40) d'un type de conductivité qui comprend au moins des premier et second évidements ;

des première et seconde régions semiconductrices (42A et 42B) d'un type de conductivité opposé formées dans une zone de surface des premier et second évidements dudit corps semiconducteur (40);

des première et seconde couches épitaxiales (44A et 44B) du type de conductivité opposé respectivement formées dans les premier et second évidements dudit corps semiconducteur (40) et présentant une concentration d'impuretés inférieure à celle desdites première et seconde régions semiconductrices (42A et 42B) ;

une structure de transistor MOS (Q2) formée dans ladite première couche épitaxiale (44A) ; et

un transistor MOS à double diffusion (Q1) formé dans ladite seconde couche épitaxiale (44B) dont le drain inclut ladite seconde région semiconductrice (42B) et ladite seconde couche épitaxiale (44B).

2. Dispositif selon la revendication 1, caractérisé en ce que ladite structure de transistor MOS comprend une structure de transistor CMOS (métal-oxyde-semiconducteur complémentaires) incluant des transistors MOS à canal P et à canal N.

3. Dispositif selon la revendication 2, caractérisé en ce que ladite structure de transistor CMOS inclut des puits P et N (52B et 54B) formés dans la zone de surface de ladite première couche épitaxiale (44A) et lesdits transistors MOS à canal P et à canal N sont respectivement formés dans lesdits puits P et N (52B et 54B).

4. Dispositif selon la revendication 1, 2 ou 3, caractérisé en ce qu'il comprend en outre une région d'impuretés (54A) du type de conductivité opposé formée de manière à recouvrir une partie de ladite seconde région semiconductrice (42B) au voisinage de la surface dudit corps semiconducteur (40).

5. Dispositif selon l'une quelconque des revendications 1 à 4, caractérisé en ce que des surfaces de jonction entre ledit corps semiconducteur (40) et lesdites première et seconde régions semiconductrices (42A et 42B) présentent une forme incurvée.

6. Dispositif selon l'une quelconque des revendications 1 à 5, caractérisé en ce qu'il comprend en outre au moins un dispositif d'arrêt de canal dudit un type de conductivité présentant une concentration en impuretés supérieure à celle dudit corps semiconducteur (40) et formé en contact avec ladite première région semiconductrice (42A) dans la zone de surface dudit corps semiconducteur (40).

7. Procédé de fabrication d'un dispositif à semiconducteur comprenant les étapes de : formation d'au moins des premier et second évidements dans une surface principale d'un corps semiconducteur (40) d'un type de conductivité ; formation de première et seconde régions semiconductrices (42A et 42B) d'un type de conductivité opposé dans les zones de surface desdits premier et second évidements contenus dans ledit corps semiconducteur (40) ; formation de première et seconde couches épitaxiales (44A et 44B) présentant une concentration en impuretés inférieure à celle desdites première et seconde régions semiconductrices (42A et 42B) dans lesdits premier et second évidements ; formation d'une structure de transistor MOS (Q2) dans ladite première couche épitaxiale (44A) ; et formation d'un transistor MOS à double diffusion (Q1) dans ladite seconde couche épitaxiale (44B).

**Patentansprüche**

1. Halbleitervorrichtung, die folgende Komponenten aufweist:
   - einen Halbleiterkörper (40) eines ersten leitenden Typs, mit mindestens einer ersten und einer zweiten Aussparung;
   - erste und zweite Halbleiterbereiche (42A und 42B) eines entgegengesetzt leitenden Typs, die in den Oberflächenbereichen der ersten und zweiten Aussparungen des Halbleiterkörpers (40) gebildet sind;
   - erste und zweite Epitaxieschichten (44A und 44B) jeweils entgegengesetzten Leitungstyps, die in der ersten und zweiten Aussparung des Halbleiterkörpers (40) gebildet sind und eine Verunreinigungskonzentration aufweisen, die niedriger als die der ersten und zweiten Halbleiterbereiche (42A und 42B) ist;
   - eine MOS-Transistorstruktur (Q2) in der ersten Epitaxieschicht (44A); und
   - einen Doppeldiffusions-MOS-Transistor (Q1) in der zweiten Epitaxieschicht (44B), dessen Drain einen zweiten Halbleiterbereich (42B) in der zweiten Epitaxieschicht (44B) aufweist.

2. Vorrichtung nach Anspruch 1, dadurch **gekennzeichnet,** daß die MOS-Transistorstruktur eine CMOS-Transistorstruktur besitzt, die aus MOS-Transistoren mit p- und n-Kanal besteht.

3. Vorrichtung nach Anspruch 2, dadurch **gekennzeichnet,** daß die CMOS-Transistorstruktur p- und n-Mulden (52B und 54B) im Oberflächenbereich der ersten Epitaxieschicht (44A) aufweist, wobei die MOS-Transistoren mit p- und n-Kanal jeweils in der p- bzw. n-Mulde (52B bzw. 54B) gebildet sind.

4.  Vorrichtung nach Anspruch 1, 2 oder 3, dadurch **gekennzeichnet,** daß sie weiter einen Verunreinigungsbereich (44A) eines entgegengesetzten Leitungstyps aufweist, der einen Abschnitt des zweiten Halbleiterbereiches (52B) nahe der Oberfläche des Halbleiterkörpers (40) bedeckt.

5.  Vorrichtung nach einem beliebigen Anspruch 1 bis 4, dadurch **gekennzeichnet,** daß die Übergangsoberflächen zwischen dem Halbleiterkörper (40) und dem ersten und zweiten Halbleiterbereich (42A und 42B) gewölbt sind.

6.  Vorrichtung nach einem beliebigen Anspruch 1 bis 5, dadurch **gekennzeichnet,** daß sie mindestens eine Kanalsperre des ersten Leitungstyps mit einer Verunreinigungskonzentration aufweist, die größer als diejenige des Halbleiterkörpers (40) ist, wobei die Sperre in Kontakt mit dem im Oberflächenbereich des Halbleiterkörpers (40) befindlichen ersten Halbleiterbereich (42A) steht.

7.  Verfahren zur Herstellung einer Halbleitervorrichtung in folgenden Schritten:
    - Herstellen einer ersten und zweiten Aussparung in einer größeren Oberfläche des Halbleiterkörpers (40) eines ersten Leitungstyps;
    - Herstellen erster und zweiter Halbleiterbereiche (42A und 42B) eines entgegengesetzten Leitungstyps in den Oberflächenbereichen der ersten und zweiten Aussparungen im Halbleiterkörper (40);
    - Herstellen erster und zweiter Epitaxieschichten (44A und 44B) mit einer Verunreinigungskonzentration, die niedriger als diejenige der ersten und zweiten Halbleiterbereiche (42A und 42B) in den ersten und zweiten Aussparungen ist;
    - Herstellen einer MOS-Transistorstruktur (Q2) in der ersten Epitaxieschicht (44A); und
    - Herstellen eines Doppeldiffusions-MOS-Transistors (Q1) in der zweiten Epitaxieschicht (44B).

EP 0 218 084 B1

## F I G. 1

## F I G. 2

EP 0 218 084 B1

# F I G. 3A

42A(n⁺)
42B(n⁺)
n⁻
44B
44A
n⁻
p⁻
40

# F I G. 3B

48  50        48  50          48  50
52  46    52(p⁺)      52(p⁺)  46  54(n⁺)   52(p⁺)      52(p⁺)    54(n⁺)  46   52(p⁺)
n⁻          42B        n⁻        44A
44B   p⁻   42A
40

# FIG. 3C

p+ 52A
p+ 52C
58
p+ 52C
58
n+ 54A
52A p+
p+ 52B
58
n+ 54B
58
p+ 52A
56

42B
n−
44B
p−
42A
n−
44A

40

# FIG. 3D

60
p+ 52A
58
56
p+ 52C
60
p+ 52C
58
n+ 54A
52A p+
60
p+ 52B
58
56
n+ 54B
60
p+ 52A

42B
n−
44B
p−
42A
n−
44A

40

EP 0 218 084 B1

FIG. 3E

FIG. 3F

FIG. 3G

FIG. 3H

# FIG. 4

62
64    66
n⁻
44B

# FIG. 5

60    66    60
64    62
68(p⁺⁺)    68(p⁺⁺)
p⁺
52B

# FIG. 6

60    66    60
64    62
n⁺
52B

# FIG. 7

62    64    66
70    p⁺⁺    n⁻    p⁺⁺    70

# FIG. 8

74
76A    72A    62    64    72A    76A
70    p⁺⁺    p⁺⁺    70
70

# F I G. 9

# F I G. 10

# F I G. 11

# F I G. 12